(19) Europäisches Patentamt
European Patent Office
Office européen des brevets

(11) Publication number: **0 487 790 A1**

# (12) EUROPEAN PATENT APPLICATION

(21) Application number: **90203163.2**

(51) Int. Cl.$^5$: **G03F 3/10**

(22) Date of filing: **30.11.90**

(43) Date of publication of application:
**03.06.92 Bulletin 92/23**

(84) Designated Contracting States:
**AT BE CH DE DK ES FR GB GR IT LI LU NL SE**

(71) Applicant: **AGFA-GEVAERT naamloze vennootschap**
**Septestraat 27**
**B-2640 Mortsel(BE)**

(72) Inventor: **Leenders, Luc Herwig**
**Lichtaartseweg 182,**
**B-2200 Herentals(BE)**
Inventor: **Schuerwegen, Ronald**
**Paepevelden 26,**
**B-2627 Schelle(BE)**
Inventor: **Daems, Eddie Roza,**
**Eigenhaard 30,**
**B-2200 Herentals,(BE)**

## (54) Whiteness controlling process and stripping film material.

(57) Process for controlling the whiteness of an image present on a permanent support, which process includes the step of providing a continuous non-photosensitive layer containing (a) fluorescent whitening agent(s) in a hydrophilic colloid binder underneath or on top of said image through transfer from a temporary support onto said permanent support before or after formation of said image thereon, said transfer proceeding by wetting the permanent support, contacting it in wet state with said continuous layer on said temporary support and stripping off the temporary support to leave said continuous layer on said permanent support.

EP 0 487 790 A1

1. Field of the Invention

The present invention relates to a process and materials for controlling the visual appearance of images present in hydrophilic colloid layer(s) or relief pattern(s).

2. Background of the Invention

The visual aspect of images obtained in hydrophilic colloid media such as in a developed and fixed gelatin silver halide emulsion layer is largely affected by background colour and light-reflectance of the support carrying the image layer. Photographs to be inspected in reflection usually have a paper support. The colour tone of the paper is an important feature determining the visual appearance of the image.

Normally to intensify the white of the paper and to increase the image contrast fluorescent whitening agents also called optical brighteners are added to the paper mass. Thereby two effects are achieved the "blueing" effect which suppresses the yellow appearance of the paper and a brightening effect which increases the luminance of the paper. The fluorescent whitening agents must remain in the photographic paper during its processing and must therefore be substantive to the cellulose of the paper or being resistant to diffusion in a covering layer, e.g. polyethylene layer, applied to the paper base.

When applying a photographic material including a gelatin silver halide emulsion layer on a paper base containing an optical brightener there will be a different tone reproduction for the highlights than in the shadows, where the effect is greatly reduced by the silver of the image. Moreover, when using paper supports containing ultraviolet radiation absorbing pigments as sizing agent, e.g. titanium dioxide, much of the fluorescence excitation light is absorbed by said ingredients and thus lost for optical brightening.

Many photographic silver halide emulsion materials have an outermost layer acting as gloss improving anti-abrasion layer. Known anti-abrasion layers are generally layers of gelatin a few microns thick optionally containing a hardening agent for gelatin such as chrom alum or some colloidal inorganic material such as silica as described e.g. by P. Glafkidès in the book Photographic Chemistry, Vol. I, Fountain Press - London (1985) p. 474 and in French Patent specification No. 1,551,591.

The use of optical brightening agents in a protective layer is described e.g. in US-P 3,650,752.

The application of a thin protective layer by coating from a liquid composition requires a cumbersome and sophisticated coating equipment which in practice is only available in factories producing photographic materials.

In some cases it is interesting to have the possibility to determine at the stage of image-processing which appearance a print should have. For example, such is the case when a photographic image is formed on a permanent support by a plurality of superposed hydrophilic colloid patterns representing a multi-colour relief image obtained by wash-off processing of hardening-developed coloured hydrophilic colloid layers.

Examples of processes for the production of multicolour relief patterns using the transfer of coloured colloid layers from a temporary support onto a permanent support are described e.g. in US-P 3,642,474, 4,701,401 and 4,710,444.

When using said processes for the production of multicolour halftone images serving as pre-press colour proof it is important that the colour tone of the proof resembles as close as possible the colour tone of the halftone prints obtained in the mechanical printing process wherein different kinds of paper supports serving as printing stock are used.

3. Summary of the Invention

It is an object of the present invention to provide a process for giving a desired visual appearance to images present in hydrophilic colloid layer(s) or relief pattern(s).

It is more particularly an object of the present invention to provide a process for controlling the whiteness of images present in hydrophilic colloid layer(s) or relief pattern(s) on a paper support.

It is a further object of the present invention to provide a sheet or weblike material, called stripping film material, for applying by wet lamination and stripping a whiteness controlling layer on top of or underneath an image or images contained in a hydrophilic colloid layer(s) or hydrophilic colloid relief pattern(s).

Other objects and advantages of the present invention will become clear from the further description.

According to the present invention a process for controlling the whiteness of an image present on a permanent support is provided which process includes the step of providing a continuous non-photosensitive layer containing (a) fluorescent whitening agent(s) in a hydrophilic colloid binder underneath or on top of said image through transfer from a temporary support onto said permanent support before or after formation of said image thereon, said transfer proceeding by wetting the permanent support, contacting it in

wet state with said continuous layer on said temporary support and stripping off the temporary support to leave said continuous layer on said permanent support.

Further according to the present invention a stripping film material is provided which material contains a hydrophobic resin support serving as temporary support whereon a continuous non-photosensitive wet-strippable and transferable layer is present, characterized in that said continuous layer is a non-photosensitive layer containing a hydrophilic colloid binder in combination with at least one fluorescent whitening agent, the hydrophilic colloid binder preferably being applied at a coverage of 0.5 to 10 g/$m^2$ and the fluorescent whitening agent being present therein at a coverage of 0.02 to 0.5 g/$m^2$.

## 4. Detailed description of the Invention

The hydrophilic colloid binder of the transferable fluorescent layer is preferably mainly gelatin (mainly means here at least 51 % by weight of the total binder content).

The gelatin can be replaced for a certain part by synthetic, semi-synthetic, or natural polymers that may be applied in water-soluble or latex form (dispersion).

Synthetic substitutes for gelatin are e.g. poly-N-vinyl pyrrolidone, polyvinyl alcohol, polyvinyl imidazole, polyvinyl pyrazole, polyacrylamide, polyacrylic acid, and derivatives thereof, in particular copolymers thereof. Natural substitutes for gelatin are e.g. other proteins such as zein, albumin and casein, cellulose, saccharides, starch, and alginates. In general, the semi-synthetic substitutes for gelatin are modified natural products e.g. gelatin derivatives obtained by conversion of gelatin with alkylating or acylating agents or by grafting of polymerizable monomers on gelatin, and cellulose derivatives such as hydroxyalkyl cellulose, carboxymethyl cellulose, phthaloyl cellulose, and cellulose sulphates.

Polymer latices that can be used in conjunction with gelatin are described in EP 0 383 283, preference being given to methyl or ethyl methacrylate latices.

The gelatin applied as hydrophilic colloid binder can be lime-treated or acid-treated gelatin. The preparation of such gelatin types has been described in e.g. "The Science and Technology of Gelatin", edited by A.G. Ward and A. Courts, Academic Press 1977, page 295 and next pages.

The amount of fluorescent whitening agent(s) with respect to the hydrophilic colloid binder of the transferable layer is preferably in a weight ratio range of 0.05/1 to 1/1.

According to an embodiment the gelatin of said continuous non-photosensitive layer is hardened to some degree, e.g. up to a degree corresponding with the addition of 0.001 g or less of formaldehyde per gram of gelatin.

The hardening of the gelatin proceeds preferably by means of a hardening agent added to the coating composition of said continuous layer before applying it to its temporary support. The hardening may proceed with any hardening agent suited for hardening gelatin known to those skilled in the art but proceeds preferably with formaldehyde. A survey of hardening agents for gelatin is given e.g. by T.N. James in the book "The Theory of the Photographic Process" 4th. ed. Macmillan Publishing Company Co., Inc. New York (1977) p. 78-84.

Preferably the hydrophilic colloid binder is applied in conjunction with at least one wetting agent acting as spreading agent in the coating of hydrophilic colloid layers, e.g. saponine or surface active agents of the anionic (carboxylate or sulphonate) type.

A survey of fluorescent whitening agents suitable for use according to the present invention is given in the book "Fluorescent Whitening Agents" - Guest Editors : R. Anliker and G. Müller (1975) Georg Thieme Publishers Stuttgart - Distribution for America by Academic Press, New York - San Francisco - London.

For avoiding diffusion (bleeding) of fluorescent whitening agents that have poor affinity for gelatin several measures can be taken such as the use of various kinds of high molecular weight compounds e.g. poly-N-vinylpyrrolidone or poly-N-vinyl-5-methyl-2-oxazolidinone described in US-P 3,269,840 which compounds have good affinity for anionic fluorescent compounds e.g. for sulphonated fluorescent stilbene derivatives such as 4,4'-diaminostilbene-2,2'-disulphonic acid structures acylated by cyanuric acid derivatives.

Other substances for fixing or trapping fluorescent whitening agents in layers containing gelatin and which may increase therefrom the brightening action are partially urethanated polyvinyl alcohol described in US-P 3,650,752 and N-vinylpyrrolidone copolymers described in published European patent application 0 106 690.

Still another technique for fixing fluorescent whitening agents in layers containing gelatin to maintain brightening action make use of latex particles that are loaded with said agents as described e.g. in Research Disclosure July 1977, item 15913 and Research Disclosure December 1979, item 18815.

According to an embodiment the transferable non-photosensitive layer containing a fluorescent whitening agent contains also gloss controlling substances, i.e. gloss improving or gloss reducing substances that are different from gelatin as described e.g. in published European patent application Nr. 0 324 192.

Gelatin alone in a covering layer has already a gloss improving effect but requires for particularly high gloss fairly high gelatin coverage, i.e. fairly thick gelatin layers. Thinner gloss improving layers can be obtained by applying the gelatin in combination with poly-N-vinylpyrrolidone.

According to an embodiment the transferable non-photosensitive layer containing a fluorescent whitening agent contains also matting agents, e.g. gloss decreasing pigments such as titanium dioxide and various forms of silica. For a more extensive description of useful matting agents reference is made to Research Disclosure December 1989, item 308119, chapter XVI. - Matting agents.

Colloidal silica suited for use in the fluorescent layer of the stripping material according to the present invention has preferably an average particle size between 10 and 100 nm. Such silica particles are available in the form of aqueous dispersions marketed under the names LUDOX (registered trade mark of I.E. du Pont de Nemours, Wilmington, Del. U.S.A.), SYTON (registered trade mark of Monsanto Chemical Corporation, Boston, Mass. U.S.A.) and KIESELSOL (registered trade mark of Farbenfabriken Bayer AG, Leverkusen West-Germany). A suitable amount of colloidal silica corresponds with a coverage of 0.1 to 2 g/$m^2$.

According to a special embodiment the fluorescent whitening agent is present in a gelatin containing layer of a stripping film material described in unpublished European patent application 90201630.2 filed 21st June 1990 and is transferred as described therein to form a fluorescent protective layer on an image present in a hydrophilic colloid layer or on an image formed by coloured hydrophilic colloid relief parts present on a permanent support.

A preferred temporary support for use in the stripping film material according to the present invention is a flexible unsubbed cellulose triacetate support.

A temporary hydrophobic resin support of the stripping film material according to the present invention may be provided with a subbing layer for said fluorescent layer in order to improve the adherence thereto of the fluorescent layer in dry state but facilitating its stripping off in wet state.

A preferred subbing layer contains a humectant to improve the swelling of the hydrophilic colloid binder of said fluorescent layer in water at the interface with the temporary support to facilitate the wet stripping of said fluoresent layer optionally together with said subbing layer by reducing the adherence thereof to said support in wet state. A suitable humectant is glycerol. In said subbing layer glycerol is applied preferably together with unhardened gelatin.

The transfer of the fluorescent layer from its temporary support proceeds preferably onto a permanent support having a hydrophilic subbing layer or such subbing layer having already on top an image contained in a hydrophilic colloid layer(s) or a relief pattern(s) of hydrophilic coloured colloid portions, said transfer proceeding by pre-wetting with water said subbing layer and the optionally already present colloid layer(s) or relief pattern(s) containing the image and pressing thereto said continuous layer in dry state, e.g. in the nip of a roller-pair exerting some pressure to the contacting materials, whereupon the temporary support is peeled off.

The present process has given very satisfactory results for controlling the whiteness of an image that is obtained as superposed hydrophilic coloured colloid relief patterns by wash-off processing of coloured imagewise hardened hydrophilic colloid layers.

According to a particular embodiment a multicolour colour proof of which the whiteness can be improved according to the present invention is prepared by the following steps :

(1) transferring a substantially non-hardened gelatin silver halide emulsion layer containing coloured pigment particles dispersed therein from a temporary support onto a permanent support being a paper base support which support may carry already a halftone relief image containing coloured hardened gelatin,

(2) imagewise exposing the non-hardened gelatin silver halide emulsion layer prior to or after carrying out said step (1),

(3) forming by hardening development a halftone image in said transferred silver halide emulsion layer,

(4) removing the formed silver image by bleach-fixing,

(5) removing selectively unhardened portions of the transferred layer by wash-off processing, and

(6) repeating steps (1), (2), (3), (4) and (5) to form at least partly superposed portions of differently coloured gelatin containing layers.

More details about such a process wherein for the formation of a multicolour proof use is made of hardening developing silver halide emulsion layers can be found in US-P 4,701,401 and 4,710,444.

The paper base support may be composed of poly-Alpha-olefin coated paper to reduce the take up of moisture and to speed up the drying.

The production of multicolour images by wash-off processing and the control of their whiteness

according to the present invention is illustrated more in detail in the following example. The percentages and ratios are by weight if not otherwise indicated.

EXAMPLE

- Preparation of photographic materials with temporary support.

On a temporary support of unsubbed cellulose triacetate provided at the rear side with a black anti-halation layer and having a thickness of 0.1 mm the following layers were applied in the order given :

(i) a silver chlorobromide-iodide emulsion (molar ratio 83.6/16/0.4) containing diffusion-resistant cyan coloured pigment and having a silver halide coverage equivalent with 0.25 g of silver per sq.m. and gelatin coverage of 1.8 g per sq.m. The emulsion was spectrally sensitized for argon ion laser light. The cyan pigment was FLEXONYL BLUE Paste (C.I. Index Nr. 74,160) which was applied at 6.3 g per liter of coating composition corresponding with 0.126 g of pigment solid per $m^2$. The pH of the coating composition was 5.0; and

(ii) a non pigmented gelatin binder layer containing per $m^2$ 0.7 g of gelatin, 0.066 g of hydroquinone and 0.095 g of matting agent on the basis of silica particles coated with urea formaldehyde resin.

In an analogous way other photographic materials with temporary support but containing magenta, yellow and black pigment coatings were prepared.

The magenta pigment coating was prepared starting with a paste sold under the name HELIOECHTCARMIN BB TEIG (Colour Index Nr. 12,485) and the yellow pigment caoting was prepared starting with a paste sold under the name HELIOECHTGELB GRN 7476 Feinteig (Colour Index Nr. 21,100). Said pigment-pastes were used in an amount of 14.5 g and 17.6 g respectively per liter of coating composition. In the black pigment coating a carbon black paste was incorporated in admixture with the above mentioned FLEXONYL BLUE-paste in an amount of 15.75 g and 1.26 g respectively per liter of coating composition.

- Preparation of the permanent support.

A double-side polyethylene coated paper with paper weight of 180 g/m2 and a polyethylene layer weight of 30 g per $m^2$ was air-knife coated at a wet coverage of 55 g per m2 with the following coating composition :

| | |
|---|---|
| distilled water | 300 ml |
| gelatin | 19.8 g |
| 20 % aqueous latex of copoly(methylmethacrylate-butadiene) (50/50) | 151 g |
| aqueous dispersion containing 2.86 % of polymethylmethacrylate and 9.5 % of gelatin | 25.5 g |
| 21.4 % aqueous dispersion of $TiO_2$ (average grain size 300 nm) containing 5.7 % of gelatin | 131 g |
| matting agent A | 5.8 g |
| matting agent B | 2.8 g |
| wetting agents of the anionic sulphonated type | 2.8 g |
| as hardening agent a 20 % aqueous solution of formaldehyde | 2.2 ml |
| distilled water up to | 1000 ml |

Matting agent A is an aqueous dispersion containing 10.7 % of amorphous silica, 6.4 % of gelatin and 4.3 % of polyethylacrylate latex particles.

Matting agent B is an aqueous dispersion containing 41.8 % of Alpha-quartz and 4.2 % of gelatin.

The weight % of $TiO_2$ with respect to the total layer composition was 29.5 in the dried layer. The coverage of $TiO_2$ was 1.54 g/$m^2$.

-Exposure.

The photographic layers on their temporary support were scanningwise halftone exposed on a commercial argon ion laser scanner operating with electronic dot generation.

The four photographic materials containing the differently pigmented coatings, having DIN A4 format, were exposed successsively for obtaining the corresponding colour selections.

- Transfer.

In the exposed state first the cyan pigment containing multilayer structure was transferred onto the permanent support as described hereinbefore by soaking the permanent support in water for 30 s and then pressing it into contact with layer (ii). By stripping apart the temporary support the composite layer structure of layers (i) and (ii) was left on the permanent support and the transferred composite layer was dried.

- Hardening development.

The transferred composite coating was hardening developed by dipping it for 30 s in an aqueous liquid, called activator bath, having following composition :

| | |
|---|---|
| potassium hydroxide | 25 g |
| potassium carbonate | 150 g |
| potassium bromide | 0.5 g |
| sodium sulphite | 2.0 g |
| 4(hydroxymethyl)4-methyl-1-phenyl-3-pyrazolidinone | 5.0 g |
| mono sodium salt of ethylenediaminetetra-acetic acid | 1.0 g |

- Bleach-fixing

The developed material was led through a bleach-fix bath containing sodium thiosulphate and the mono sodium,iron(III) salt of ethylenediamine tetra-acetic acid.

- Wash-off processing.

To obtain a cyan coloured relief image the hardening developed and bleach-fix processed material was wash-off processed with a warm (40 °C) water spray. The relief image was dried.

For obtaining a multi-colour relief image the described magenta, yellow and black pigment coatings were exposed and processed analogously to form superposed relief paterns on the same permanent support already containing the cyan image.

- Preparation of the stripping film material

An unsubbed cellulose triacetate support having a thickness of 0.1 mm was coated with an aqueous composition to obtain a whiteness improving fluorescent layer containing following ingredients at the defined coverage in g/m2 :

| | |
|---|---|
| gelatin | 2.99 g/m2 |
| aqueous dispersion containing 2.86 % of polymethylmethacrylate latex particles and 9.5 % of gelatin | 0.40g/m2 |
| poly-N-vinylpyrrolidinone | 0.84 g/m2 |
| saponine | 0.04 g/m2 |
| i-$C_{14}H_{29}OSO_3Na$ (spreading agent) | 0.07 g/m2 |
| 30 % aqueous colloidal silica dispersion | 3.30 g/m2 |
| 2 % aqueous dispersion of fluorescent whitening agent A (see formula hereinafter) in 4.5 % aqueous gelatin solution | 5.00 g/m2 |

Structural formula of whitening agent A

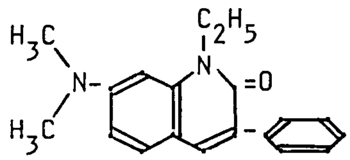

- Transfer of the whiteness improving layer.

In a first embodiment, called embodiment A, the whiteness improving layer was applied by wet lamination and stripping onto the above defined permanent support before forming the cyan relief pattern thereon. For the transfer of the whiteness improving layer an apparatus as schematically represented in Figure 3 of European Patent Application No. 90201630.2 was used.

In a second embodiment, called embodiment B, the whiteness improving layer was applied by wet lamination and stripping onto the above defined superposed relief patterns (cyan, magenta, yellow and black).

A light reflectance measurement at 412 nm wavelength was carried out on the material of embodiment A without and with the fluorescent whitening agent. The reflectance values expressed in percentage were 76 and 82 respectively proving a strong blueing and corresponding whitening effect obtained with the transferred fluorescent layer. Analogous whitening results were obtained in embodiment B.

## Claims

**1.** Process for controlling the whiteness of an image present on a permanent support, which process includes the step of providing a continuous non-photosensitive layer containing (a) fluorescent whitening agent(s) in a hydrophilic colloid binder underneath or on top of said image through transfer from a temporary support onto said permanent support before or after formation of said image thereon, said transfer proceeding by wetting the permanent support, contacting it in wet state with said continuous layer on said temporary support and stripping off the temporary support to leave said continuous layer on said permanent support.

**2.** Process according to claim 1, wherein said hydrophilic colloid binder is mainly gelatin.

**3.** Process according to claim 1 or 2, wherein in said continuous layer the hydrophilic colloid binder is present at a coverage of 0.5 to 10 $g/m^2$ and the fluorescent whitening agent is present at a coverage of 0.02 to 0.5 $g/m^2$.

**4.** Process according to claim 2, wherein the amount of fluorescent whitening agent(s) with respect to gelatin is in a weight ratio range of 0.05/1 to 1/1.

**5.** Process according to claim 2, wherein the gelatin in said continuous layer is present in conjunction with synthetic, semi-synthetic, or natural polymers that may be applied in water-soluble or latex form.

**6.** Process according to claim 2, wherein the gelatin is present in conjunction with a gloss improving substance or matting agent.

**7.** Process according to any of claims 2 to 6, wherein the gelatin is used in conjunction with poly-N-vinyl pyrrolidone.

**8.** Process according to any of claims 2 to 7, wherein said continuous layer contains latex particles that are loaded with said fluorescent whitening agent(s).

**9.** Process according to any of claims 2 to 8, wherein the gelatin of said continuous non-photosensitive layer is hardened to a degree corresponding with the addition of 0.001 g or less of formaldehyde per gram of gelatin.

**10.** Process according to any of the preceding claims, wherein said continuous layer contains colloidal silica.

**11.** Process according to any of the preceding claims, wherein said temporary support is an unsubbed cellulose triacetate support.

**12.** Process according to any of the preceding claims, wherein the transfer of the continuous layer from its temporary support proceeds onto a permanent support having a hydrophilic subbing layer or such subbing layer having already on top an image contained in a hydrophilic colloid layer(s) or a relief

pattern(s) of hydrophilic coloured colloid portions, said transfer proceeding by pre-wetting with water said subbing layer and the optionally already present colloid layer(s) or relief pattern(s) containing the image and pressing thereto said continuous layer in dry state, whereupon the temporary support is peeled off.

**13.** Process according to claim 12, wherein said image is obtained as superposed hydrophilic coloured colloid relief patterns obtained by wash-off processing of coloured imagewise hardened hydrophilic colloid layers.

**14.** A stripping film material containing a hydrophobic resin support serving as temporary support whereon a continuous non-photosensitive wet-strippable and transferable layer is present, characterized in that said continuous layer is a non-photosensitive layer containing a hydrophilic colloid binder in combination with at least one fluorescent whitening agent.

**15.** A stripping film material according to claim 14, wherein the hydrophilic colloid binder is applied at a coverage of 0.5 to 10 $g/m^2$ and the fluorescent whitening agent is present therein at a coverage of 0.02 to 0.5 $g/m^2$.

European Patent Office

# EUROPEAN SEARCH REPORT

Application Number

EP 90 20 3163

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| Y,D | EP-A-324192 (AGFA-GEVAERT NV.)<br>* the whole document *<br>--- | 1-15 | G03F3/10 |
| Y | EP-A-365355 (HOECHST CELANESE CORPORATION)<br>* claims 1, 8 *<br>--- | 1-15 | |
| A | EP-A-357324 (HOECHST CELANESE CORPORATION)<br>* abstract *<br>----- | 1 | |
| | | | **TECHNICAL FIELDS SEARCHED (Int. Cl.5)** |
| | | | G03F |

The present search report has been drawn up for all claims

| Place of search | Date of completion of the search | Examiner |
|---|---|---|
| THE HAGUE | 02 AUGUST 1991 | RASSCHAERT A. |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P0401)